# EUROPEAN PATENT APPLICATION

(11) **EP 3 868 921 A1**
(43) Date of publication of application: **25.08.2021**
(21) Application number: 20158741.7
(22) Date of filing: 21.02.2020
(51) Int. Cl.: C25B 1/00, C25B 3/04, C25B 9/06, C25B 9/16, C25B 11/04, H01L 31/0392

(54) **DEVICE FOR SOLAR LIGHT DRIVEN CO2 REDUCTION IN WATER**

(71) Applicant: Université de Paris, 75006 Paris (FR); Centre National de la Recherche Scientifique, 75016 Paris (FR); Universite de Nantes, 44000 Nantes (FR)
(72) Inventor: ROBERT, Marc, 75019 PARIS (FR); BOUTIN, Etienne, 94300 VINCENNES (FR); PATI, Palas Baran, 44000 NANTES (FR); ODOBEL, Fabrice, 44300 NANTES (FR); BARREAU, Nicolas, 44300 NANTES (FR)
(74) Representative: Demulsant, Xavier

(57) **Abstract**

Method and photo-electrochemical system using Cu(In,Ga)Se₂ CIGS for reducing electrochemically CO₂ into CO using as catalyst a metal complex with quaterpyridine ligand, the electrochemical cell comprising a cathode, an anode, a cathodic electrolyte comprising water as the solvent, and a power supply providing the energy necessary to trigger the electrochemical reactions.

## Description

### FIELD OF THE INVENTION

The invention generally relates to solar light driven CO₂ reduction in water.

### BACKGROUND OF THE INVENTION

Conversion of CO₂ to useful chemicals is an attractive technique for CO₂ capture and sequestration. However, it requires a high energy input to break the strong C=O bond of CO₂ molecules. The utilization of solar energy, especially visible light energy, provides a promising approach to solve the energy issue for CO₂ conversion. Among visible-light photocatalytic CO₂ conversion, three different processes have been considered in prior art, namely photocatalytic CO₂ reduction with water, photocatalytic CO₂ hydrogenation, and photocatalytic reforming of CO₂ and CH₄.

The invention generally relates to solar light photocatalytic CO₂ reduction in water, this kind of process attempting to mimic natural transformation of atmospheric CO₂ and water to chemical fuels using sunlight as the sole energy input, and being thus named artificial photosynthesis.

Artificial photosynthesis is a very important research area, because it represents one of the most credible solutions to reduce our dependence of fossil fuels and to produce storable chemical fuels or raw materials for chemical industry with a low carbon footprint.

Directly inspired from natural photosynthesis, which consists in activation of atmospheric CO₂ into biomass with sunlight, solar driven conversion of CO₂ into CO is certainly a valuable and key transformation for artificial photosynthesis.

Indeed, CO is strategic building block for chemical industry, since it can be transformed into virtually any liquid carbon-based hydrocarbons by d-metal catalyzed Fischer-Tropsch process or either into methanol by reduction or into acetic acid by Cativa-Monsanto process, for which the markets and the requisite infrastructures are already in place. CO is also used for purification of Nickel in the Mond process and the production of phosgene useful for preparing isocyanates, polycarbonates and polyurethanes.

Artificial photosynthesis is generally approached with photovoltaic cells to generate a sufficient photovoltage which is then supplied to an electrolyzer consisting of a cathode for the CO₂ reduction and an anode for the water oxidation. Proper electrocatalysts are employed on the two electrodes so as to expedite the reaction rate and improve the reaction selectivity. One of the first photocathode for photoelectrochemical (PEC) cell used for CO₂ reduction was p-type GaP reported in 1978 by Halmann et al (Nature, 1978, 275, 115-116). Among various semiconductors, Si, InP, GaP, GaAs, attracted most of the efforts in prior art. The main product for the PEC CO₂ reduction in most nonaqueous solvents on p-Si, p-lnP, p-GaAs, and p-GaP in various nonaqueous solvents was CO, with varying FE.

An example of an electrolytic device for solar light reduction of CO₂ is given in US 2015/0218719 (Panasonic) describing a carbon dioxide reduction device including a cathode chamber holding a first electrolyte solution that contains CO₂; an anode chamber holding a second electrolyte solution; a proton conducting membrane disposed in a connecting portion between these chambers; a cathode electrode and an anode electrode. The cathode electrode has a CO₂ reduction reaction region composed of a metal or a metal compound, and the anode electrode has a photochemical reaction region composed of nitride semiconductors. The photochemical reaction region of the anode electrode has a multilayer structure of a GaN layer and an AlₓGa₁₋ₓN layer containing Mg (0<x≦/0.25). The anode electrode is disposed in such a manner that the AlₓGa₁₋ₓN layer can be exposed to light.

US 2017/0309840 (Alibabaei) discloses electrodes useful in dye sensitized photoelectrosynthesis cells, a core/shell nanoparticle having a chromophore and a catalyst, or a chromophore-catalyst assembly comprising Ru, linked to the shell material.

CN 107845848 (Univ Hebei) discloses a gallium-nitride-based device for artificial photosynthesis. The gallium-nitride-based device comprises a glass substrate, a molybdenum layer, a CIGS (Copper-Indium-Gallium-Selenide) layer, a CdS layer, an intrinsic ZnO layer, a TCO layer, a bonding interface layer, a GaN layer, an InGaN layer and an NiO nanoparticle layer from bottom to top. The gallium-nitride-based device can be used in the artificial photosynthesis as a photoanode material and plays a very important role in reducing carbon-dioxide emission.

The great challenges presented to PEC CO₂ reduction require appropriate catalysts and energy input to realize a highly efficient, selective and low energy consumption device that minimizes the electric energy demand and utilizes the solar energy as the greatest extent during the aqueous CO₂ conversion. Thus, it poses several fundamental challenges in chemical catalysis, electrochemistry, photochemistry, and semiconductor physics and engineering.

With these considerations in mind, the present inventors have explored the use of photocathode to harvest solar light and provide photogenerated electrons to efficiently activate a catalyst to reduce CO₂ into CO in water.

### SUMMARY OF THE INVENTION

The present invention relates to a photo-electrochemical system to reduce CO₂ into CO, comprising an electrochemical cell with:
- an anodic compartment with:
   - an anode with a current collector,
   - an anodic electrolyte solution comprising a solvent, and an anodic supporting electrolyte, the solvent being water;
- a cathodic compartment with:
   - a cathodic electrolyte solution comprising the solvent, and a cathodic supporting electrolyte, the solvent being water,
   - the reagent CO₂;
   - a photocatalytic electrode comprising a chalcogenide film surmounted by a multilayer of:
- a layer of Cu(Inₓ,Ga_{y})Se₂ CIGS or an alloy of Cu(Inₓ,Ga_{y})Se_{w}S_{z}; x being comprised in between 0 and 1, and y = 1-x and w comprised in between 0 and 2 with z = 2-w;
- a layer having material selected in the group comprising CdS, ZnS,
- a protecting layer,
- a final molecular layer which is a molecular catalyst grafted onto the surface of the protecting layer to electrochemically reduce CO₂ into CO.

Advantageously, the molecular catalyst is chosen between the list:
- metal porphyrin with one or several ⁺N(C₁-C₄ alkyl)₃ groups, with the metal chosen among: Iron, Cobalt;
- metal phthalocyanine, with the metal chosen among: Iron, Cobalt;
- metal phthalocyanine with the metal chosen among: Iron, Cobalt, with one or several groups among: ⁺N(C₁-C₄ alkyl)₃ , F, C(CH₃)₃, or
- cobalt quater pyridine.

Advantageously, the molecular catalyst is a cobalt complex with the planar tetradentate ligand 2,2':6',2":6",2"'-quaterpyridine (Co-qPyH).

Advantageously, the molecular catalyst presents anchoring groups which are:
- phosphonic acid,
- alcoxysilane, or
- hydroxamic acid,
to be grafted on the surface.

Advantageously, the structure of the cobalt complex with phosphonic acid (**Co-qPyH**) is as follow:

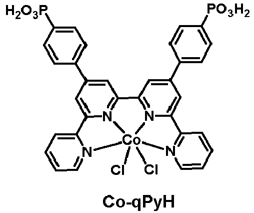

Advantageously, the protective layer is selected in the group comprising TiO₂, SrTiO₃, SnO₂, metal doped TiO₂.

Advantageously, the system comprises a layer selected in the group comprising: ZnO or AZO, Indium Tin Oxide (ITO), between the layer having material selected in the group comprising CdS, ZnS, and the protecting layer.

Advantageously, the molecular catalyst is grafted on mesoporous TiO₂ or SnO₂ or SrTiO₃ to form a mesoTiO₂(SnO₂)|**Co-qPyH** electrode.

Advantageously, chalcogenides photovoltaic cell is coupled with the mesoTiO₂|**Co-qPyH** electrode.

In certain embodiments, the photo-electrochemical system presents:
- a gas diffusion porous cathode which comprises, on a current collector, electrochemically inert, the molecular catalyst incorporated in the porous cathode with a geometric surface S, to electrochemically reduce the CO₂ gas into gaseous CO, with an eventual by-production of gaseous H₂, the cathode being a CIGS photovoltaic cell or a photocathode;
- an anodic compartment comprising:
   an anode with a current collector, and on the current collector, at least a catalyst to electrochemically oxidize H₂O to O₂,
   an anodic electrolyte solution, at a controlled flow rate Qa, comprising a solvent, and an anodic electrolyte, the solvent being water,
- a cathodic compartment comprising:
   a cathodic electrolyte solution, at a controlled flow rate Qc, comprising a solvent, and a cathodic electrolyte, the solvent being water,
   a gas diffusion porous cathode which comprises, on a gas diffusion porous current cathode collector, the molecular catalyst incorporated in the porous cathode with a geometric surface S, to electrochemically reduce the gas comprising CO₂ into gaseous CO, with a by-production of gaseous H₂,
- a channel for flowing the reagent gas CO₂, at a controlled flow rate Qg, onto or through the surface S of the gas diffusion porous current cathode collector;
- a cathodic electrolyte solution inlet and a cathodic electrolyte solution outlet connected to the cathodic compartment, to circulate the cathodic electrolyte solution, and the remaining reagent gas CO₂ and the product gas CO by the outlet.

In certain embodiments, the photovoltaic cell is lit from the side where the molecular catalyst is, or laterally from the photovoltaic cell.

Advantageously, the pH of anodic electrolyte solution and the pH of cathodic electrolyte solution is between 4 to 14.

The present invention relates to a photo-electrochemical system to reduce CO₂ into CO, comprising an electrochemical cell with:
- an anodic compartment with:
   - an anode with a current collector,
   - an anodic electrolyte solution comprising a solvent, and an anodic supporting electrolyte, the solvent being water;
- a cathodic compartment with:
   - a cathodic electrolyte solution comprising the solvent, and a cathodic supporting electrolyte, the solvent being water,
   - the reagent CO₂;
   - a cathode which comprises, a current collector which is connected in series with a photovoltaic junction in charge of absorbing light and providing the energy necessary to trigger the photoelectrochemical reactions involving the reagent
   - the photovoltaic junction being situated outside the cathodic electrolyte and connected to the cathode through a wire, comprising a chalcogenide photovoltaic cell which presents a multilayer structure:
      - a layer having material which is Cu(Inₓ,Ga_{y})Se₂ CIGS or an alloy of Cu(Inₓ,Ga_{y})Se_{w}S_{z}, x being comprised in between 0 and 1, and y = 1-x and w comprised in between 0 and 2 with z = 2-w,
      - a layer having material selected in the group comprising: CdS, ZnS,
   - the cathode having on the current collector one or several metallic oxide layers and a molecular catalyst to electrochemically reduce CO₂ into CO, which is grafted on the top metallic oxide layer, to be in the cathodic electrolyte; the chalcogenides photovoltaic cell.

Advantageously, the molecular catalyst is chosen between the list:
- metal porphyrin with one or several ⁺N(C₁-C₄ alkyl)₃ groups, with the metal chosen among: Iron, Cobalt;
- metal phthalocyanine, with the metal chosen among: Iron, Cobalt;
- metal phthalocyanine with the metal chosen among: Iron, Cobalt, with one or several groups among: ⁺N(C₁-C₄ alkyl)₃ , F, C(CH₃)₃, or
- cobalt quater pyridine.

Advantageously, the molecular catalyst is a cobalt complex with the planar tetradentate ligand 2,2':6',2":6",2"'-quaterpyridine (**Co-qPyH**).

Advantageously, the protective layer is selected in the group comprising TiO₂, SrTiO₃, SnO₂, metal doped TiO₂

Advantageously, the molecular catalyst is grafted on mesoporous TiO₂ or SnO₂ or SrTiO₃ to form a mesoTiO₂(SnO₂)|**Co-qPyH** electrode.

In particular embodiments, on the anode current collector, at least a catalyst is disposed. This catalyst can be used to electrochemically oxidize H₂O to O₂. In other embodiments, the catalyst can be used to oxidize Cl⁻ into Cl₂.

The use of water as solvent is advantageous over e.g. DMF (dimethylformamide) or ACN (acetonitrile). As it will appear in the detailed description of embodiments, the photo electrochemical cell can also be used with DMF or ACN as solvent.

In particular embodiments, the photo-electrochemical cell is saturated with CO₂ gas, both the atmosphere and the electrolyte solution being saturated with CO₂. The photo-electrochemical cell of the present invention can be used as a closed system regarding CO₂ gas, e.g. to for a tight study of gas evolution. Advantageously, the photo-electrochemical cell of the present invention can be used in an open environment, with a flow of CO₂ which can saturate the electrolyte. Advantageously, the CO₂ gas flow is passing through the photocathode.

Advantageously, the CO₂ pressure is of 1 bar (atmospheric pressure), preferably in a cathodic compartment of the photo-electrochemical cell. Higher CO₂ pressures, e.g. between 2 and 30 bars can be used, preferably only in a cathodic compartment of the photo-electrochemical cell.

The anode is a carbon, iridium oxide, cobalt oxide, cobalt phosphate, stainless steel, platinum or any bimetallic mixed oxide catalytically active towards water oxidation electrode.

In the present invention, the electrochemical reduction of CO₂ into CO is particularly selective. In particular, no formation of formic acid is advantageously observed.

The present invention is directed to addressing the effects of one or more of the problems set forth above. The following presents a simplified summary of the invention in order to provide a basic understanding of some aspects of the invention. This summary is not an exhaustive overview of the invention. It is not intended to identify key of critical elements of the invention or to delineate the scope of the invention. Its sole purpose is to present some concepts in a simplified form as a prelude to the more detailed description that is discussed later.

While the invention is susceptible to various modification and alternative forms, specific embodiments thereof have been shown by way of example in the drawings. It should be understood, however, that the description herein of specific embodiments is not intended to limit the invention to the particular forms disclosed.

It may of course be appreciated that in the development of any such actual embodiments, implementation-specific decisions should be made to achieve the developer's specific goal, such as compliance with system-related and business-related constraints. It will be appreciated that such a development effort might be time consuming but may nevertheless be a routine understanding for those or ordinary skill in the art having the benefit of this disclosure.

### BRIEF DESCRIPTION OF THE DRAWINGS

The objects, advantages and other features of the present invention will become more apparent from the following disclosure and claims. The following non-restrictive description of preferred embodiments is given for the purpose of exemplification only with reference to the accompanying drawings in which:

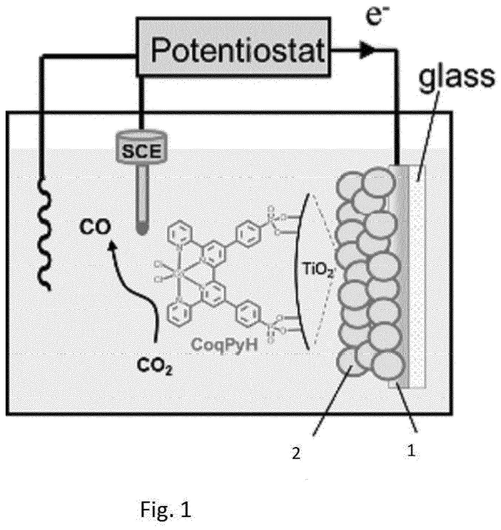

FIG.1 is a representation of a mesoporous TiO₂ film coated with CoqPyH;
FIG.2 is a representation of a EC-PV system;
FIG.3 is a representation of a CIGS based photoelectrocatalytic cell;
FIG.4 is a linear sweep voltammetry of a mesoTiO₂|**Co-qPyH** electrode with electrolyte purged with argon or purged with CO₂;
FIG.5 is a long term electrolysis with applied potential -1.15 V vs. SCE, conditions: 0.1 M KHCO₃ aqueous medium (pH = 6.8) saturated with CO₂;
FIG.6 is a linear sweep voltammetry of a mesoTiO₂|**Co-qPyH** electrode connected to CIGS solar cells with chopped light illumination, conditions: 0.1 M KHCO₃ aqueous medium (pH = 6.8) saturated with CO₂;

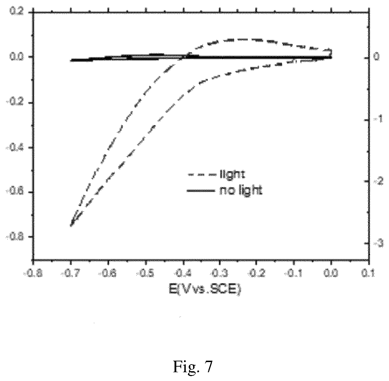

FIG.7 is a linear sweep voltammetry of a mesoTiO₂|**Co-qPyH** electrode connected to CIGS solar cells under continuous irradiation, conditions: 0.1 M KHCO₃ aqueous medium (pH = 6.8) saturated with CO₂;

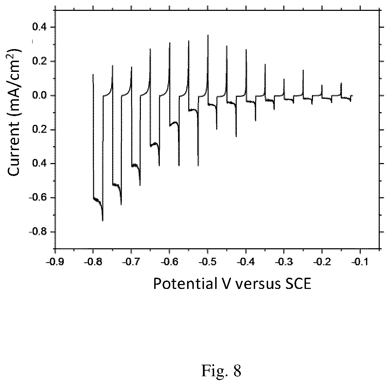

FIG.8 is a linear sweep voltammetry of a CIGS|TiO₂|**Co-qPyH** electrode with chopped light illumination, conditions: 0.1 M KHCO₃ aqueous medium (pH = 6.8) saturated with CO₂;

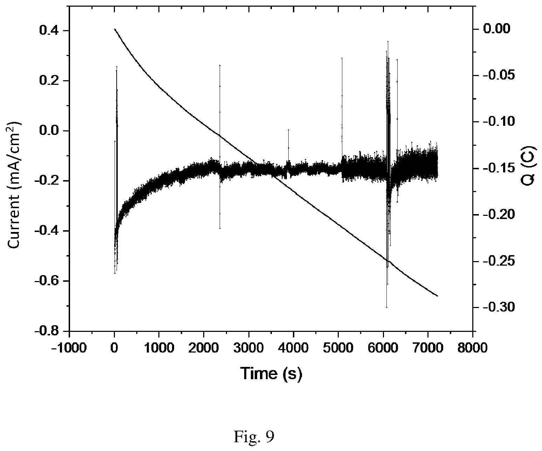

FIG.9 is a linear sweep voltammetry of a CIGS|TiO₂|**Co-qPyH** electrode with applied potential -0.7 V vs. SCE and continuous sunlight irradiation, conditions: 0.1 M KHCO₃ aqueous medium (pH = 6.8) saturated with CO₂;

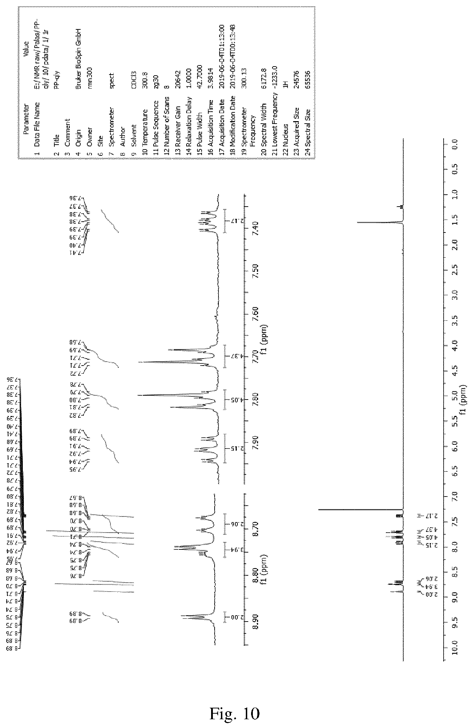

FIG.10 is ¹H NMR spectrum of compound 2, namely 4',4"-dibromo-2,2':6',2":6",2"-quaterpyridine;

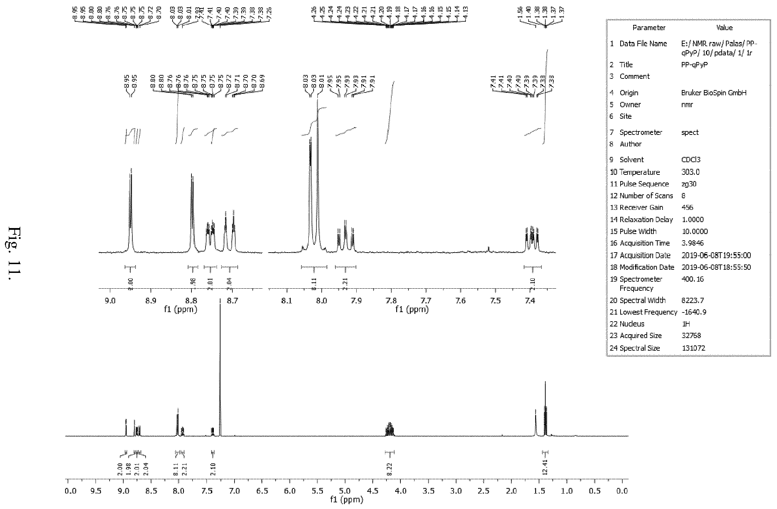

Fig.11 is ¹H NMR spectrum of compound 3, namely tetraethyl ([2,2':6',2":6",2"'-quaterpyridine] -4',4"-diylbis (4,1 phenylene)) bis (phosphonate);

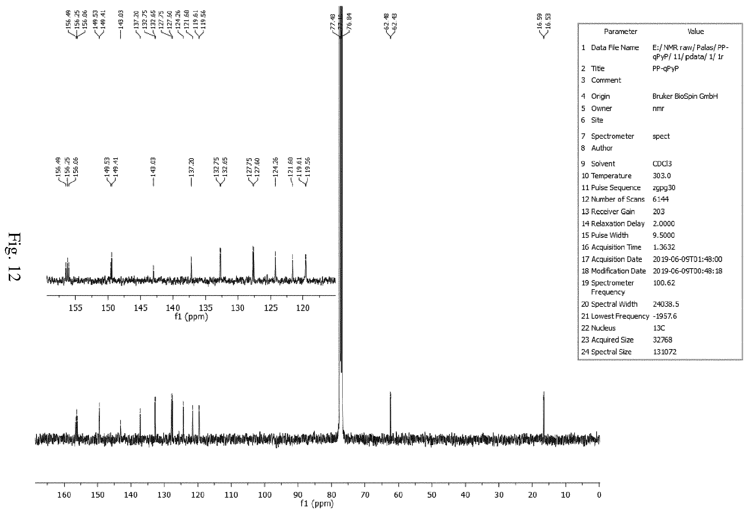

Fig.12 is ¹³C NMR spectrum of compound Co-qPyE;
Fig.13 is electronic absorption spectrum of compound Co-qPyE recorded in DMF;
Fig.14 is electronic absorption spectrum of **Co-qPyH** grafted on film of meso-TiO₂;
Fig.15 is ATIR spectra of **Co-qPyH** in powder form and grafted on meso-TiO₂ film;

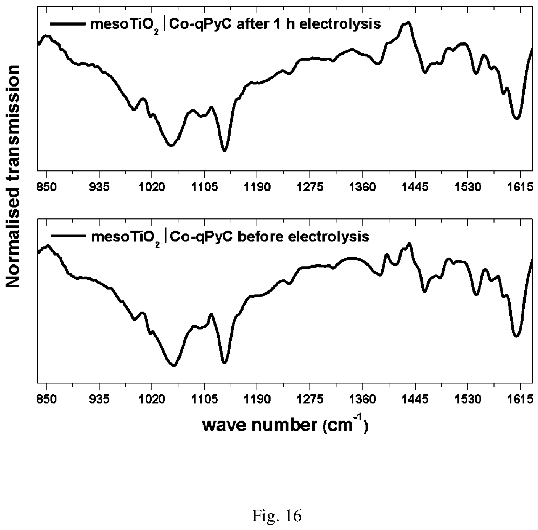

Fig.16 is ATR-IR spectra recorded before and after 1h of electrolysis in CO₂ saturated aqueous KHCO₃ 0.1 M on mesoporous TiO₂ films;
Fig.17 is cyclic voltammogram of **Co-qPyE** (0.01mM) in DMF where GC used as working electrode, Pt-rod as counter electrode with 20 mV/s scan rate. Ferrocene was used as external standard;
Fig.18 is a large scale electrolysis of the meso-TiO₂ film with **Co-qPyH** grafted and externally wired to the CIGS solar (configuration shown in Fig. 2), conditions: 0.1 M KHCO₃ aqueous medium (pH = 6.8) saturated with CO₂;
Fig.19 is a long term electrolysis of the photoelectrocatalytic cell (CIGS/TiO₂/Co-qPyH, configuration shown in Fig. 3), conditions: 0.1 M KHCO₃ aqueous medium (pH = 6.8) saturated with CO₂, applied potential -0.7 V vs SCE;
Fig.20 is a scanning electron microscope cross section image of the Mo/CuIn_{0.1}Ga_{0.9}Se₂/CdS/AZO film;
Fig. 21 is a long term electrolysis of the photoelectrocatalytic cell (CIGS/TiO₂/Co-qPyH, configuration shown in Fig. 3), conditions: 0.5 M KHCO₃ aqueous medium (pH = 7.2) saturated with CO₂, applied potential -0.7 V vs SCE.

### DETAILED DESCRIPTION OF ILLUSTRATIVE EMBODIMENTS

Phosphonic acid functionalized catalyst (**Co-qPyH**) was synthesized by the route described in Scheme S1.

Briefly, 4',4"-dibromo-2,2':6',2":6",2"-quaterpyridine (2) was isolated with 23% yield through from the reaction of 1,6-bis(4-bromophenyl)hexa-1,5-diene-3,4-dione 1 with the Kröhnke reagent, N-[2-(2-pyridyl)-2-oxethyl]pyridinium iodide, in the presence of ammonium acetate.

The phosphonate ester groups were introduced with a Hirao cross-coupling reaction between dibromo-2,2':6',2":6",2"-quaterpyridine (2) and diethylphosphite in 92% yield upon microwave activation.

Then, the diethyl phosphonate functionalized quaterpyridine ligand (3) was complexed with CoCl₂.6H₂O to afford Co-qPyE with a 45% yield.

Hydrolysis of phosphonate ester groups of Co-qPyE cannot be accomplished in refluxing at 6 N HCI as usual, owing to high risk of decomplexation, but using SiMe₃Br in dry DMF presence of triethylamine to trap the generated HBr to afford **Co-qPyH** with 82% yield.

### Materials and methods

¹H, ¹³C and ³¹P NMR spectra were recorded on an AVANCE 300 UltraShield BRUKER and AVANCE 400 BRUKER.

Chemical shifts for ¹H and ¹³C NMR spectra are referenced relative to residual protium in the deuterated solvent (CDCl₃ δ = 7.26 ppm for ¹H and δ = 77.16 ppm for ¹³C).

NMR spectra were recorded at room temperature, chemical shifts are written in ppm and coupling constants in Hz.

High-resolution mass (HR-MS) spectra were obtained either by electrospray ionization coupled with high resolution ion trap orbitrap (LTQ-Orbitrap, ThermoFisher Scientific) working in ion-positive or ion-negative mode.

Electrochemical measurements were made under an argon atmosphere in the mixture DMF with 0.1 M Bu₄NPF₆.

Cyclic voltammetry experiments were performed by using a SP300 BioLogic potentiostat/galvanostat.

A standard three-electrode electrochemical cell was used.

Potentials were referred to a saturated calomel electrode as internal reference.

All potentials are quoted relative to SCE.

The working electrode was a glassy carbon disk and the auxiliary electrode was a Pt wire.

UV-visible absorption spectra were recorded on a Variant Cary 300, using 1 cm path length cells.

ART-IR spectra were recorded on BRUKER Tensor 27.

Chemicals were purchased from Sigma-Aldrich or Alfa Aesar and used as received.

Thin-layer chromatography (TLC) was performed on aluminum sheets precoated with Merck 5735 Kieselgel 60F₂₅₄. Column chromatography was carried out either with Merck 5735 Kieselgel 60F (0.040-0.063 mm mesh).

(1E,5E)-1,6-bis(4-bromophenyl)hexa-1,5-diene-3,4-dione (1) was synthesized as previously reported literature method (D. Lebedev, Y. Pineda-Galvan, Y. Tokimaru, A. Fedorov, N. Kaeffer, C. Copéret and Y. Pushkar, J. Am. Chem. Soc., 2018, 140, 451-458).

To a vigorously stirred solution of 4-bromobenzaldehyde (11.1 g, 6 mmol) and piperidine (0.6 ml, 0.6 mmol) in MeOH, a solution of 2,3-butadione (2.58 g, 3 mmol) was added dropwise using a dropping funnel over 10 minutes. The reaction mixture was heated to reflux for overnight. The solution was cooled in an ice-bath and the obtained orange precipitate was filtered and washed with diethyl ether. The orange compound was dried under vacuum to yield 2.71 g of compound 1. This compound (**1**) was used directly for the next reaction without doing any further purification.

### 4',4"-bis(4-bromophenyl)-2,2':6',2":6",2"'-quaterpyridine (2):

(1E,5E)-1,6-bis(4-bromophenyl)hexa-1,5-diene-3,4-dione (**1**) (420 mg, 1.0 mmol) was added to a solution of N-[2-(2-pyridyl)-2-oxethyl]pyridinium iodide (652 mg, 3.26 mmol) and anhydrous ammonium acetate (8 g, excess) in absolute ethanol (40 ml) and the mixture heated under reflux for 24 h. After cooling, the precipitate filtered and washed with diethyl ether. Compound (**2**) is really insoluble in common organic solvent. 140 mg of compound (**2**) was obtained as off-white powder with 23% yield.
¹H NMR (ppm, 300 MHz, 298 K, CDCl₃) δ 8.88 (d, J = 1.8 Hz, 2H), 8.75 (m, 2H), 8.74 (d, J = 1.8 Hz, 2H), 8.68 (dt, J = 4.8, 1.2 Hz, 2H), 7.92 (td, J = 8.1, 1.8 Hz, 2H), 7.79 (d, J = 8.7 Hz 4H), 7.68 (d, J = 8.7 Hz, 4H), 7.38 (dt, J = 4.8, 1.2 Hz, 2H); HRMS m/z calcd for C₃₂H₂₁Br₂N₄ [M+H]⁺ 619.0133, found 619.0137.

### Tetraethyl ([2,2':6',2":6",2"'-quaterpyridine]-4',4"-diylbis(4,1-phenylene))bis(phosphonate) (compound 3):

Compound (2) (100 mg, 0.16 mmol), Pd(PPh₃)₄ (17 mg, 0.015 mmol) and Cs₂CO₃ (114 mg, 0.35 mmol) were combined in anhydrous THF (4 mL) in a 10 mL microwave vial equipped with a stirrer bar under argon. Diethylphosphite (107 mg, 0.78 mmol) was added by syringe before the vial and purged with Ar for another 10 minutes. The vial was sealed and the reaction mixture heated to 110 °C for 2.5 h. The reaction mixture was filtered to give a yellow solution and then the solvent was evaporated under reduced pressure. The resulting brown residue was dissolved in CH₂Cl₂ (20 mL) and stirred with decolourising charcoal for 30 minutes then filtered over celite prior to removal of the solvent under reduced pressure to produce an oily bright yellow residue. The residue was dissolved in acetone (5 mL) and filtered through a short silica plug eluting with acetone (25 mL) to give a pale yellow solution. The solvent volume was reduced to ≈5 mL cold pentane was added until the compound (**3**) precipitated out from the solution. Compound (**3**) was isolated as white powder (108 mg, 92%).
¹H NMR (ppm, 400 MHz, 298 K, CDCI3) δ 8.95 (d, J = 1.6 Hz, 2H), 8.80 (d, J = 1.6 Hz, 2H), 8.75 (m, 2H), 8.70 (dt, J = 8.0, 0.8 Hz, 2H), 8.01-8.03 (m, 8H), 7.93 (td, J = 7.6, 1.6 Hz 4H), 7.38 (dt, J = 6.0, 1.2 Hz, 2H) ), 4.13-4.26 (m, 8H), 1.38 (t, J = 6.8 Hz, 12H); ¹³C HRMS (ppm, 100 MHz, 298 K, CDCl₃) δ 156.5, 156.3, 156.1, 149.5, 149.4, 143.0, 137.2, 132.8, 132.7, 127.8, 127.6, 124.3, 121.6, 119.61, 119.56, 62.5, 62.4, 16.6, 16.5; HRMS m/z calcd for C40H41N4O6P2 [M+H]⁺ 735.3501, found 735.3497.

### Cobalt[tetraethyl ([2,2':6',2":6",2"'-quaterpyridine]-4',4"-diylbis(4,1-phenylene))bis(phosphonate)]bis-chloro (Co-qPyE):

CoCl₂.6H₂O (75.5 mg, 0.31 mmol) was dissolved in methanol (6 mL). A solution of compound (**3**) (233 mg, 0.31 mmol) in chloroform (6 mL) was added slowly with stirring at ambient temperature. A brown solid was formed gradually upon stirring and the mixture was stirred for 2 h. The solid was filtered and washed with methanol and chloroform to remove the unreacted ligand and CoCl₂.6H₂O. The solid was dried under vacuum to a result yellow powder. Yield: 120 mg (45 %). Anal. Calcd. for C₄₀H₄₀Cl₂CoN₄O₆P₂: C, 55.57; H, 4.66; N, 6.48. Found: C, 55.70; H, 4.76; N, 6.98; HRMS m/z calcd for C₄₀H₄₀CoN₄O₆P₂ [M-2Cl-]²⁺ 793.1755, found 793.1762.

### Cobalt[2,2':6',2":6",2"'-quaterpyridine]-4',4"-diylbis(4,1-phenylene)bis(phosphonic acido)]bis-chloro (Co-qPyH):

**Co-qPyE** (50 mg, 0.06 mmol) was taken in an oven dried 3-necked round bottom flask kept under Ar atmosphere. 6 mL extra dry DMF was added followed by 0.25 mL distilled triethylamine was added to the mixture. Then 0.15 mL of SiMe₃Br was added to the reaction mixture drop wise and the reaction mixture was stirred for 48 h at 45 °C. The reaction mixture was cooled and solvent was removed through reduced pressure. The residue was diluted with very dilute aqueous solution of HCI (pH = 6.8) to remove quaternary ammonium salt formed during reaction and protonation of phosphonic acid. The brown precipitate was filtered and washed with water and dried under vacuum to produce 36 mg (yield = 82%) of **Co-qPyH.** Compound too insoluble to record ¹H NMR spectrum in any solvent.

Anal. Calcd. for C₃₂H₂₄Cl₂CoN₄O₆P₂·3.1H2O: C, 47.56; H, 3.77; N, 6.93. Found: C, 48.07; H, 4. 23; N, 6.93. HRMS m/z calcd for C₃₂H₂₄CoN₄O₆P₂ [M-2Cl-]²⁺ 681.0503, found 681.0494.

### Fabrication of TiO₂ films

FTO conductive glass substrates (F-doped SnO₂) 1 were purchased from Pilkington (TEC8). Three successive layers **2** of mesoporous TiO₂ were then screen printed using a transparent colloidal paste (Dyesol DSL 18NR-T) with 10-minute long drying steps at 100°C between each layer. Overall, the thickness of the mesoporous layer is 12 µm, and the thickness of the scattering layer is 4 µm. The obtained substrates were then sintered at 450°C, following a progressive heating ramp (325°C for 5 min, 375°C for 5 min, 450°C for 30 min).

### Fabrication of CIGS electrodes

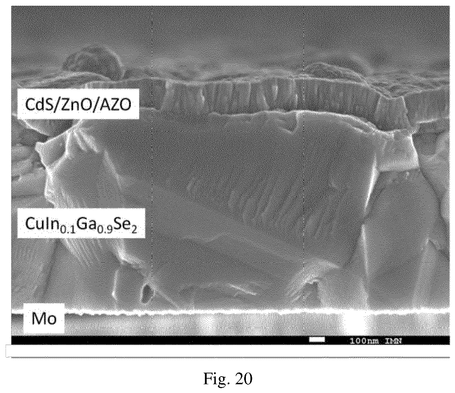

CuIn_{0.1}Ga_{0.9}Se₂ (CIGS) layers **3** were grown onto Mo-coated **4** soda-lime glass substrates by co-evaporation from elemental sources. The soda-lime glass **5** consists of 1 mm thick microscope slides (1×3 inch²). Mo back contact is deposited by DC-sputtering, with total thickness of 500 nm. The process used for CIGS deposition is known as CuPRO process *(*J. Kessler, C. Chityuttakan, J. Lu, J. Schöldström and L. Stolt, Prog. Photovoltaics Res. Appl., 2003, 11, 319-331), which consists in keeping In and Ga fluxes constant and changing Cu flux such that nominal composition of the growing film undergoes Cu-poor/Cu-rich/Cu-poor transitions needed for high performance devices (N. Barreau, T. Painchaud, F. Couzinié-Devy, L. Arzel and J. Kessler, Acta Materialia, 2010, 58, 5572-5577). Substrates temperature was kept constant (580°C) during the whole deposition, and the thickness of final films is about 2 µm. The n-type partner of the junction is 40 nm-thick CdS layer **6** grown by chemical bath deposition. The p-CIGS/n-CdS heterojunction is finally covered with RF-sputtered ZnO/ZnO:Al bilayer **7.** The applied ZnO:AI layers thickness was compromise chosen at 300 nm (Rsheet = 20 Ω/sq) although usually thinner for such wide gap absorber-based solar cells. A scanning electron microscope cross section image of the film is shown in Figure 20.

Two device configurations were investigated.

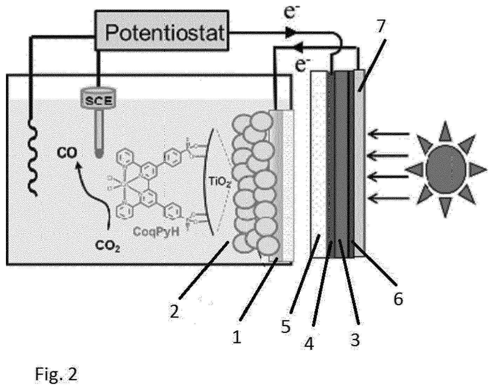

Device represented in Fig. 2: in this configuration, external front (-) and back (+) lateral contacts were taken on ZnO:AI layer **7** and Mo layer **4,** respectively. In that case, the 0.8 cm²-sized cells show relatively low fill factors because of harming series resistance due to too high ZnO:AI sheet resistance (or too low thickness). The typical PV parameters of these cells are: Voc ∼ 750 mV, Jsc ∼ 15 mA/cm², 0.4 < FF < 0.5.

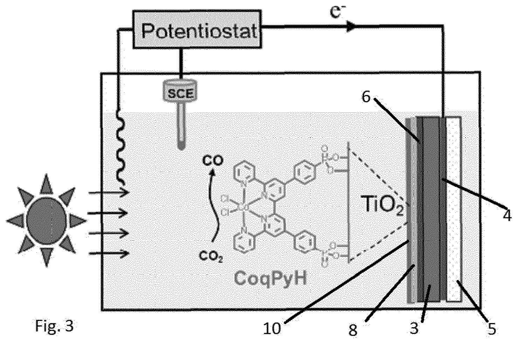

Device represented in Fig. 3: in this configuration, the only contact needed is that on Mo layer **4.** To protect the complete device from the electrolyte during catalyst grafting and system operation, a 2-4 nm-thick dense TiO₂ layer **10** (1-2 nm thick) was RF-sputtered onto the device.

The typical PV parameters of these cells before TiO₂ protective layer deposition were: Voc ∼ 750 mV, Jsc ∼ 15 mA/cm², 0.6 < FF < 0.7.

### Catalyst loading on the electrodes (TiO₂ or CIGS)

A 0.2 mM solution of **Co-qPyH** in 10 mL methanol was prepared then two drops of water was added and the mixture was sonicated for 10 minutes with continuous degassing by Ar. Then electrodes were dipped into this solution and this bath was heated at 45 °C for 48 h. The electrodes were finally rinsed with methanol and dried under nitrogen atmosphere.

### Results

**Co-qPyH** is partly soluble in MeOH solution, whereas **Co-qPyE** is fairly soluble in acetonitrile and DMF.

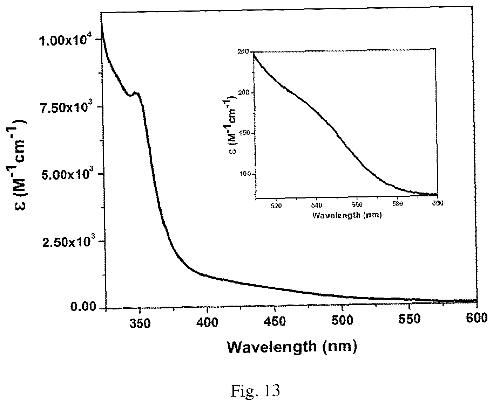

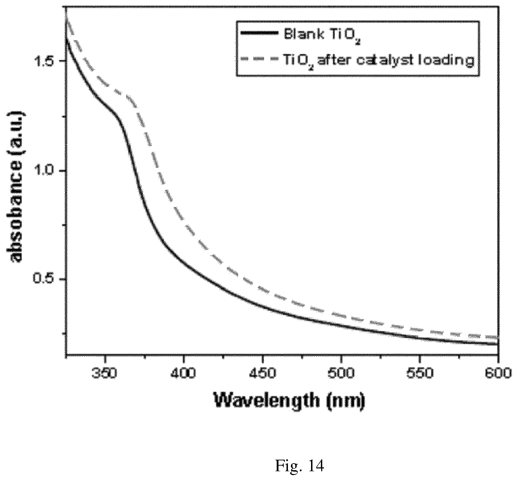

The electronic absorption spectra of **Co-qPyE** exhibits a strong absorption band at 350 nm, which is assigned to the intra ligand π-π* transition on the quaterpyridine (Figure 13). The weak and broad band with maxima at 448 nm and 540 nm can be attributed to the metal-to-ligand charge transfer (MLCT) transition for **Co-qPyH** (Figure 13). This complex exhibits only a weak absorbance in the visible spectrum and therefore it leaves the electrode almost transparent to most of the incoming solar irradiation. The absorption spectra recorded on TiO₂ surface, before and after catalyst loading, confirm that it was loaded on the semiconducting surface (Figure 14).

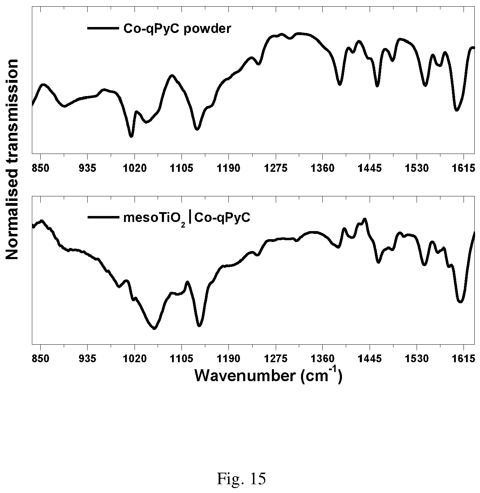

Moreover, the resemblance of fingerprint region of ATR-IR spectra of powder **Co-qPyH** and after grafting on TiO₂ film is another piece of evidence that the catalyst was grafted on the surface (Figure 15).

For example, the bands -1390, -1490, -1546 and -1601 cm⁻¹ assigned for aromatic ring stretching vibration corroborate the structural preservation of catalyst upon immobilization.

On the other hand, the disappearance of band near 893 cm⁻¹ (P-OH) of **Co-qPyH** after surface attachments while the presence of the band at 1243 cm⁻¹ (P=O stretching) suggest the usual bidentate binding of phosphonate on TiO₂ surface, where P=O unit of phosphonic acid is not involved in the linkage.

Inductively coupled plasma optical emission spectrometry (ICP-OES) measurements indicate a catalyst loading of 28.7 ± 4.3 nmol/cm² on mesoporous TiO₂ film.

XPS analyses show the characteristic signal of N at 133 eV and that of cobalt at 780 eV.

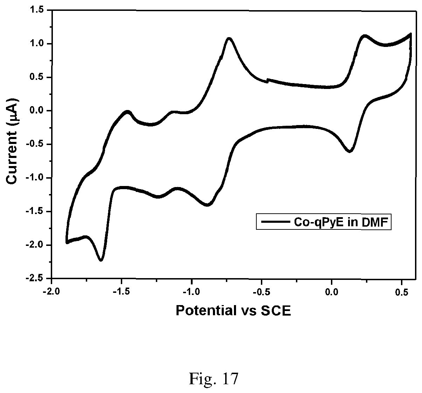

The cyclic voltammogram of **Co-qPyE** in DMF solution shows the reversible oxidation process at 0.18 vs SCE assigned to Co^{III}-Co^{II} redox couple (Figure 17).

Upon reductive scan, two quasi-reversible reduction couples at ca. -0.81 V vs. SCE assignable as the Co^{II}-Co^{I} couple and then to further reduction of the complex.

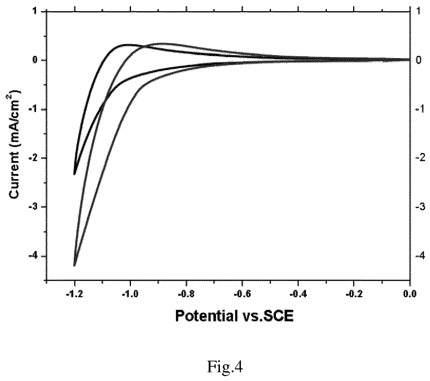

The catalytic activity of **Co-qPyH** was then explored after surface attachment on mesoporous TiO₂ film (mesoTiO₂|**Co-qPyH**) by cyclic voltammetry in CO₂ saturated DMF in presence of 1 M phenol (Fig. 4).

A prominent catalytic wave appears with an onset catalytic potential at - 1.2 vs. SCE.

To analyse the selectivity and faradaic efficiency a long term electrolysis was done by applying -1.2 V vs SCE bias potential during hours.

In DMF, the catalytic current was around 0.2 mA/cm² and the selectivity towards CO₂ reduction to CO over the competitive proton reduction was excellent (98.5% of CO for only 1.5% of H₂).

In 0.1 M KHCO₃ aqueous medium (pH = 6.8) saturated with CO₂, the catalytic onset potential is anodically shifted to -1.0 V vs. SCE.

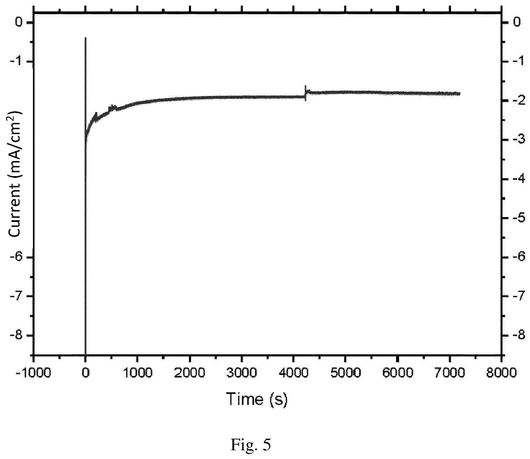

Long term electrolysis at potential -1.15 V vs. SCE for two hours led to an average catalytic current of 2 mA/cm² and the gas chromatography analysis of the products indicates the production of CO with 81% selectivity and 96% FE along with 19% of H₂ (Fig. 5).

Interestingly, the current density remains relatively stable, since after a little drop of about 20% in the first 15 minutes, it is stabilized for 2 hours without significant change.

The ATR spectrum of the electrode before and after one hour of electrolysis are very similar and the intensity of the characteristic bands of the catalyst were almost not altered, indicating that leaching of the catalyst was feeble, probably the dual consequence of a strong binding via the phosphonate and a poor solubility of the catalyst into the aqueous medium.

The above results indicate that the cobalt quaterpyridine complex has kept its catalytic activity after its functionalization with phosphonic acid and its immobilization of a quasi-transparent mesoporous TiO₂ electrode.

It delivers higher current density in water than in DMF.

Compared to the immobilization on carbon nanotube (M. Wang, L. Chen, T.-C. Lau and M. Robert, Angew. Chem. Int. Ed., 2018, 57, 7769-7773) in similar conditions the current density measured here is lower, but the TiO₂ inorganic support presents the advantage of being transparent towards a large portion of the sunlight and therefore compatible as a support on photoelectrodes.

The high electrocatalytic performances of mesoTiO₂|**Co-qPyH** electrode motivate the inventors to develop a photocatalytic CO₂ reduction system.

Towards this objective, two strategies were adopted, the first one consists in coupling a CIGS photovoltaic cell with the above mesoTiO₂|**Co-qPyH** electrode (Fig.2) and the second one is based on the fabrication of a photoelectrochemical cell (PEC) by grafting the **Co-qPyH** catalyst onto a thin TiO₂ layer preliminary deposited on a CIGS film **8** (Fig.3).

Photovoltaic cell coupled to an electrolyser (PV-EC, Fig. 2) is a valuable approach to utilize the photogenerated charges in a solar cell to activate a substrate in a solution as the photoactive materials are not in contact with the solution.

The mesoTiO₂|**Co-qPyH** electrode was connected to CIGS solar cells (Glass/Mo/Cu(In_{0.1}Ga_{0.9}Se₂/CdS/ZnO/AZO) and the photocurrent was measured as a function of the applied potential through light on-off cycles (Fig. 2). The CIGS solar cell exhibits a sort circuit photocurrent density (Jsc) of 14.8 mA/cm², an open circuit voltage of 750 mV, a fill factor (ff) of 67% resulting in a power conversion efficiency of 7.4% recorded under AM 1.5 (1000 W/m²).

Under light irradiation, the onset catalytic potential was anodically shifted to -0.3 V vs. SCE, corresponding to a 700 mV potential gain with respect to the catalytic activity in the dark. This is among the lowest potential ever reported for solar driven CO₂ reduction.

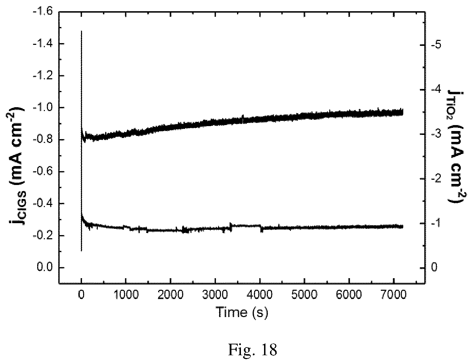

A long term electrolysis experiment was then carried out with this EC-PV system and an average current density of 0.25 and 0.9 mA/cm² were obtained under applying a bias potential of -0.5 V and -0.7 V vs. SCE respectively (Figure 18).

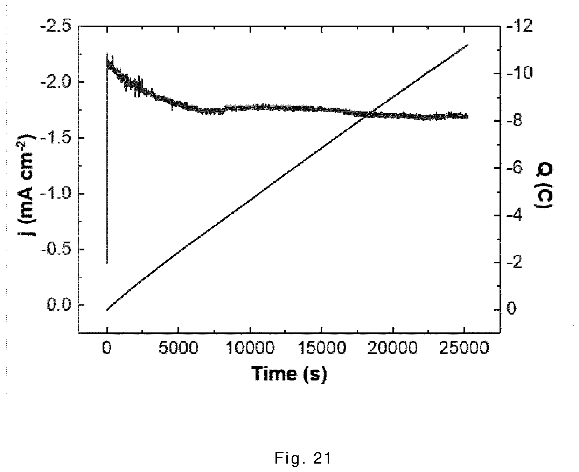

Interestingly, the current was stable during due the course of seven hours of photo-electrolysis. The experiment performed led to an average current density of 1.78 mA/cm² after optimization of pH and electrolyte conditions (Table 2 and Figure 21).

Analysis of the reaction products by GC indicates that the selectivity towards CO is 84% when the bias potential was -0.7 vs SCE (Table 2).

This photocatalytic system compares very well with previous reports in terms of selectivity and efficiency.

These encouraging results prompted the inventors to investigate the fabrication of an integrated photoelectrochemical cell (PEC) with the CoqPyH catalyst directly immobilized on a CIGS based photocathode (Fig. 3).

For that purpose, the surface of the CIGS/CdS/AZO was first protected by a dense layer of TiO₂ (1 to 40 nm thick, and more advantageously 1 to 2 nm) deposited by sputtering and the catalyst was loaded by chemisorption using the same conditions as those used for mesoporous TiO₂ film.

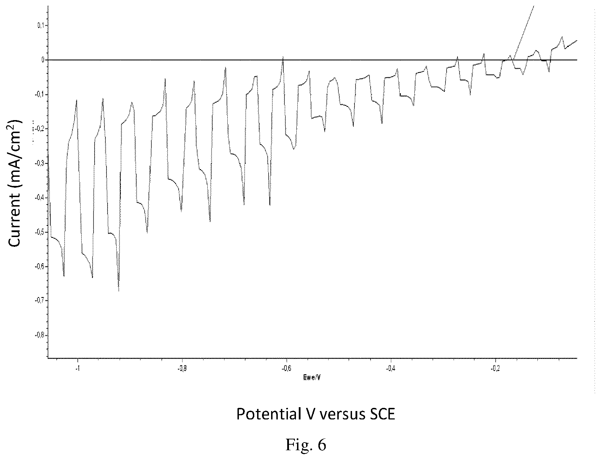

Linear sweep voltammetry with chopped illumination in 0.1 M KHCO₃ aqueous solution revealed a photoresponse at onset potential of -0.3 V vs. SCE, while a control experiment on bare CIGS/CdS/ZnO/AZO/TiO₂ electrode showed negligible photocurrent modulation in the same conditions (Fig.6).

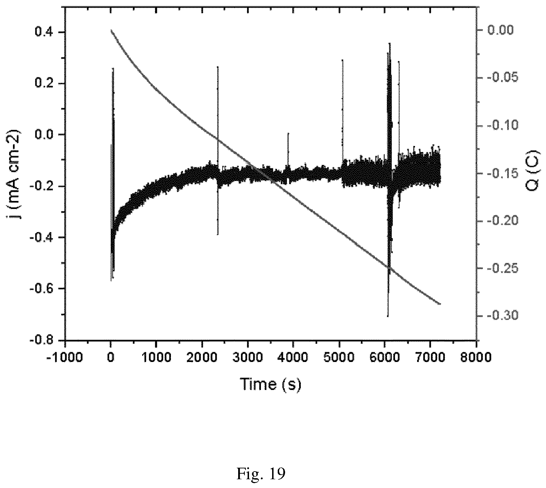

To confirm that the photoresponse was due to catalytic reduction of CO₂, a long term photoelectrocatalysis experiment was carried out at a bias potential of -0.7 V (Fig. 19)

During this experiment, photocurrent slightly decays for the first half an hour and then stabilized to 200 µA/cm² and remains stable for the remaining time of the two hours electrolysis (Fig.19).

The generated product was analyzed through GC and 91% selectivity for CO was obtained with 9% of H₂ (Table 2).

Another reason of unstability can be the corrosion of CIGS electrode, particularly if the AZO underlayer gets into contact with the aqueous environment owing to most probable pineholes inside the thin TiO₂ layer.

One of the object of the invention is solar light driven CO₂ reduction in water by a CIGS copper chalcogenide based photocathode functionalized by a molecular cobalt quaterpyridine catalyst.

The invention has a large number of advantages over prior art.

The **Co-qPyH** system is superior in every aspect compare to other molecular hybrid system, first one being that the photocatalytic reaction was fully demonstrated in pure aqueous medium with 91% of selectivity towards CO₂ reduction to CO over proton reduction.

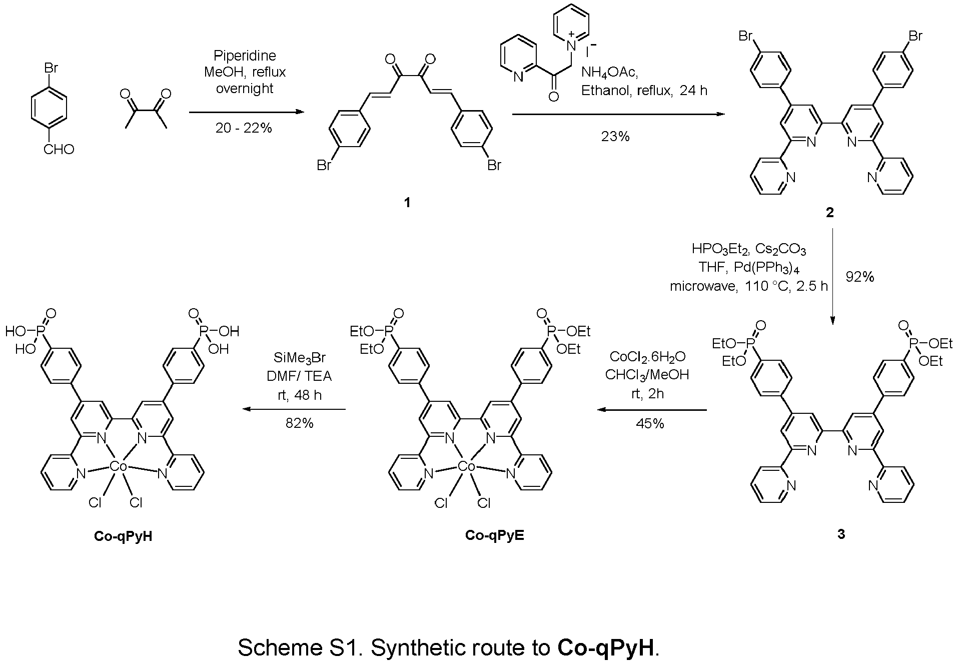

**Table 1. Electrocatalytic performances of mesoTiO₂|Co-qPyH electrodes**

| In DMF 1M phenol at -1.2 V vs SCE after 2 h of electrolysis | | In 0.1M KHCO₃ at -1.15 V vs SCE after 2 h of electrolysis | |
|---|---|---|---|
| CO production | H₂ production | CO production | H₂ production |
| Overpotential: 0.446 | | Overpotential: 0.396 | |
| Selectivity: 98.6% | Selectivity: 1.4% | Selectivity: 81% | Selectivity: 19% |
| FE: 98.6% | FE: 1.4% | FE: 81% | FE: 19% |

**Table 2: Photocatalytic performances of the photocatalytic systems recorded in different conditions.**

| Systems | Conditions^{a} | J (mA/cm²) | CO | | | H₂ | |
|---|---|---|---|---|---|---|---|
| | | | Selectivity (%) | FE (%) | η^{b} | Selectivity (%) | FE (%) |
| PV-EC | -0.7 | 0.90 | 87 | 96 | -0.054 | 13 | 14 |
| | -0.5 | 0.25 | 80 | 80 | -0.254 | 20 | 20 |
| | -0.7 | 1.78 | 82-85 | 82-85 | -0.030 | 15-18 | 15-18 |
| PEC | -0.7 | 0.17 | 91 | 91 | -0.054 | 9 | 9 |

| | | | | | | | |
|---|---|---|---|---|---|---|---|
| ^{a}applied potential in V *vs.* SCE. ^{b}overpotential defined as E⁰(CO₂/CO) - E_{electrolysis} in V calculated at pH = 6.8 (entries 1,2 and 4, 2h electrolysis) and at pH = 7.2 (entry 3, 7h electrolysis). | | | | | | | |

## Claims

1. Photo-electrochemical system to reduce CO₂ into CO, comprising an electrochemical cell with:
- an anodic compartment with:
• an anode with a current collector,
• an anodic electrolyte solution comprising a solvent, and an anodic supporting electrolyte, the solvent being water;
- a cathodic compartment with:
• a cathodic electrolyte solution comprising the solvent, and a cathodic supporting electrolyte, the solvent being water,
• the reagent CO₂;
• a photocatalytic electrode comprising a chalcogenide film surmounted by a multilayer of:
- a layer of Cu(Inₓ,Ga_{y})Se₂ CIGS or an alloy of Cu(Inₓ,Ga_{y})Se_{w}S_{z} x being comprised in between 0 and 1, and y = 1-x and w comprised in between 0 and 2 with z = 2-w,
- a layer having material selected in the group comprising: CdS, ZnS,
- a protecting layer,
- a final molecular layer which is a molecular catalyst grafted onto the surface of the protecting layer, to electrochemically reduce CO₂ into CO.

2. The photo-electrochemical system according to claim 1, wherein the molecular catalyst being chosen between the list:
- metal porphyrin with one or several ⁺N(C₁-C₄ alkyl)₃ groups, with the metal chosen among: Iron, Cobalt;
- metal phthalocyanine, with the metal chosen among: Iron, Cobalt;
- metal phthalocyanine with the metal chosen among: Iron, Cobalt, with one or several groups among: ⁺N(C₁-C₄ alkyl)₃ , F, C(CH₃)₃, or
- cobalt quater pyridine.

3. The photo-electrochemical system according to claims 1-2, wherein the molecular catalyst is a cobalt complex with the planar tetradentate ligand 2,2':6',2":6",2"'-quaterpyridine (**Co-qPyH**).

4. The photo-electrochemical system according to claims 1-3, wherein the molecular catalyst presents anchoring groups which are:
- phosphonic acid,
- alcoxysilane, or
- hydroxamic acid,
to be grafted on the surface.

5. The photo-electrochemical system according to claim 4, wherein the structure of the cobalt complex with phosphonic acid (**Co-qPyH**) is as follow:

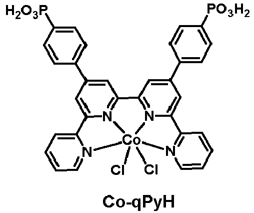

6. The photo-electrochemical system according to claims 1-5, wherein the protective layer is selected in the group comprising TiO₂, SrTiO₃, SnO₂, metal doped TiO₂.

7. The photo-electrochemical system according to claims 1-6, wherein the system comprises a layer selected in the group comprising: ZnO or AZO, Indium Tin Oxide (ITO), between the layer having material selected in the group comprising CdS, ZnS, and the protecting layer.

8. The photo-electrochemical system according to claims 6-7, wherein the molecular catalyst is grafted on mesoporous TiO₂ or SnO₂ or SrTiO₃ to form a mesoTiO₂(SnO₂)|**Co-qPyH** electrode.

9. The photo-electrochemical system according to claim 8, wherein chalcogenides photovoltaic cell is coupled with the mesoTiO₂|**Co-qPyH** electrode.

10. The photo-electrochemical system according to claims 1-9, wherein the system presents:
- a gas diffusion porous cathode which comprises, on a current collector, electrochemically inert, the molecular catalyst incorporated in the porous cathode with a geometric surface S, to electrochemically reduce the CO₂ gas into gaseous CO, with an eventual by-production of gaseous H₂, the cathode being a CIGS photovoltaic cell or a photocathode;
- an anodic compartment comprising:
an anode with a current collector, and on the current collector, at least a catalyst to electrochemically oxidize H₂O to O₂,
an anodic electrolyte solution, at a controlled flow rate Qa, comprising a solvent, and an anodic electrolyte, the solvent being water,
- a cathodic compartment comprising:
a cathodic electrolyte solution, at a controlled flow rate Qc, comprising a solvent, and a cathodic electrolyte, the solvent being water,
a gas diffusion porous cathode which comprises, on a gas diffusion porous current cathode collector, the molecular catalyst incorporated in the porous cathode with a geometric surface S, to electrochemically reduce the gas comprising CO₂ into gaseous CO, with a by-production of gaseous H₂,
- a channel for flowing the reagent gas CO₂, at a controlled flow rate Qg, onto or through the surface S of the gas diffusion porous current cathode collector;
- a cathodic electrolyte solution inlet and a cathodic electrolyte solution outlet connected to the cathodic compartment, to circulate the cathodic electrolyte solution, and the remaining reagent gas CO₂ and the product gas CO by the outlet.

11. The photo-electrochemical system according to claims 1-10, wherein the photovoltaic cell is lit from the side where the molecular catalyst is, or laterally from the photovoltaic cell.

12. The photo-electrochemical system according to claims 1-11, wherein the pH of anodic electrolyte solution and the pH of cathodic electrolyte solution is between 4 to 14.

13. Photo-electrochemical system to reduce CO₂ into CO, comprising an electrochemical cell with:
- an anodic compartment with:
• an anode with a current collector,
• an anodic electrolyte solution comprising a solvent, and an anodic supporting electrolyte, the solvent being water;
- a cathodic compartment with:
• a cathodic electrolyte solution comprising the solvent, and a cathodic supporting electrolyte, the solvent being water,
• the reagent CO₂;
• a cathode which comprises, a current collector which is connected in series with a photovoltaic junction in charge of absorbing light and providing the energy necessary to trigger the photoelectrochemical reactions involving the reagent
• the photovoltaic junction being situated outside the cathodic electrolyte and connected to the cathode through a wire, comprising a chalcogenide photovoltaic cell which presents a multilayer structure:
- a layer having material which is Cu(Inₓ,Ga_{y})Se₂ CIGS or an alloy of Cu(Inₓ,Ga_{y})Se_{w}S_{z}, x being comprised in between 0 and 1, and y = 1-x and w comprised in between 0 and 2 with z = 2-w,
- a layer having material selected in the group comprising: CdS, ZnS,
• the cathode having on the current collector one or several metallic oxide layers and a molecular catalyst to electrochemically reduce CO₂ into CO, which is grafted on the top metallic oxide layer, to be in the cathodic electrolyte; the chalcogenides photovoltaic cell.

14. The photo-electrochemical system according to claim 13, wherein the molecular catalyst being chosen between the list:
- metal porphyrin with one or several ⁺N(C₁-C₄ alkyl)₃ groups, with the metal chosen among: Iron, Cobalt;
- metal phthalocyanine, with the metal chosen among: Iron, Cobalt;
- metal phthalocyanine with the metal chosen among: Iron, Cobalt, with one or several groups among: ⁺N(C₁-C₄ alkyl)₃ , F, C(CH₃)₃, or
- cobalt quater pyridine.

15. The photo-electrochemical system according to claims 13-14, wherein the molecular catalyst is a cobalt complex with the planar tetradentate ligand 2,2':6',2":6",2"'-quaterpyridine (Co-qPyH).

16. The photo-electrochemical system according to claims 13-15, wherein the protective layer is selected in the group comprising TiO₂, SrTiO₃, SnO₂, metal doped TiO₂

17. The photo-electrochemical system according to claims 13-16, wherein the molecular catalyst is grafted on mesoporous TiO₂ or SnO₂ or SrTiO₃ to form a mesoTiO₂(SnO₂)|**Co-qPyH** electrode.
